**Europäisches Patentamt**

**European Patent Office**

**Office européen des brevets**

(19)

(11) Veröffentlichungsnummer: **0 177 845**
**A1**

(12) # EUROPÄISCHE PATENTANMELDUNG

(21) Anmeldenummer: **85112213.5**

(22) Anmeldetag: **26.09.85**

(51) Int. Cl.⁴: **H01L 23/52** , H01L 21/90

(30) Priorität: **28.09.84 DE 3435780**

(43) Veröffentlichungstag der Anmeldung:
**16.04.86 Patentblatt 86/16**

(84) Benannte Vertragsstaaten:
**AT DE FR GB IT NL**

(71) Anmelder: **Siemens Aktiengesellschaft**
**Berlin und München Wittelsbacherplatz 2**
· **D-8000 München 2(DE)**

(72) Erfinder: **Kokkotakis, Nicolas, Dr. rer. nat. Phys.**
**Balanstrasse 152**
**D-8000 München 90(DE)**

(54) **Integrierter Schaltkreis mit Mehrlagenverdrahtung und Verfahren zu seiner Herstellung.**

(57) Es wird ein integrierter Schaltkreis mit Mehrlagenverdrahtung vorgestellt, bei dem auf eine isolierende Schicht (IS)
oberhalb eines Substrates (SU) eine erste Leiterbahnebene
mit Leiterbahnen (AL1) aufgebracht und strukturiert wird. Darauf werden zwei Isolierschichten (IS1, IS2) , beispielsweise
aus Polyimid bzw. Siliciumnitrid, aufgetragen und strukturiert,
um Kontaktlöcher (KL) zu erzeugen. Erfindungsgemäß wird
dann eine dritte Isolierschicht (IS3) z.B. aus Siliciumnitrid,
aufgetragen und so strukturiert, daß in den Kontaktlöchern
(KL) seitliche Flanken (F1) der ersten beiden Isolierschichten
(IS1, IS2) bedeckt bleiben. Darauf wird eine zweite Leiterbahnebene aufgebracht und zu Leiterbahnen (AL2) strukturiert.
Zwischen weitere, aufzubringende Leiterbahnebenen mit Leiterbahnen (AL3) werden jeweils weitere drei Isolierschichten
(IS10, IS20, IS30) aufgetragen und strukturiert, entsprechend
den ersten drei Isolierschichten (IS1, IS2, IS3).

# FIG 5

EP 0 177 845 A1

## Integrierter Schaltkreis mit Mehrlagenverdrahtung und Verfahren zu seiner Herstellung

Die Erfindung betrifft einen integrierten Schaltkreis mit Mehrlagenverdrahtung und ein Verfahren zu seiner Herstellung nach den Oberbegriffen der Patentansprüche 1 und 7.

Aus der DE-OS 3234907 ist ein Verfahren zur Herstellung eines integrierten Schaltkreises der eingangs genannten Art bekannt. Daraus läßt sich auch ein nach diesem Verfahren hergestellter Schaltkreis ableiten.

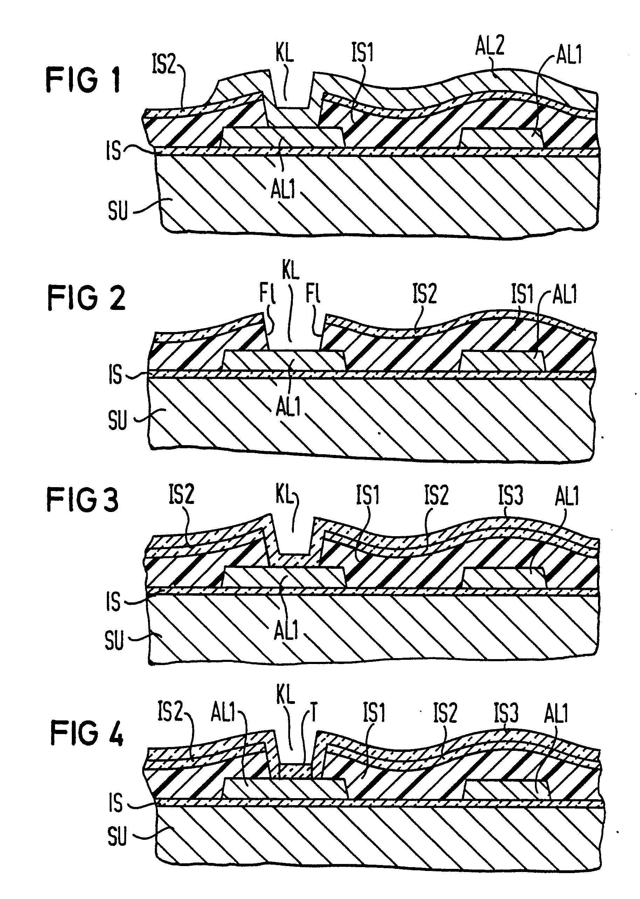

Ein ausschnittweiser Querschnitt durch diesen Schaltkreis ist in Fig. 1 der vorliegenden Anmeldung dargestellt. Er wird im folgenden kurz diskutiert:

Der bekannte Schaltkreis enthält an einer Oberfläche eines Substrates SU, das elektrisch aktive Schaltungsteile enthält (aus Gründen der Übersichtlichkeit nicht dargestellt) eine isolierende Schicht IS, beispielsweise aus Siliciumdioxid. Oberhalb dieser isolierenden Schicht IS ist eine erste Leiterbahnebene mit Leiterbahnen AL1 angeordnet. Zur elektrischen Isolation der Leiterbahnen AL1 dieser Leiterbahnebene von einer zweiten Leiterbahnebene mit Leiterbahnen AL2 dienen zwei Isolierschichten IS1, IS2, wobei die erste dieser Isolierschichten IS1 aus hygroskopischem Material (z.B. Polyimid) ist. Die zweite dieser Isolierschichten IS 2 ist dagegen us einem Feuchtigkeit abstoßenden Material (z.B. Siliciumnitrid). Sie schützt die erste Isolierschicht IS1 vor eindringender Feuchtigkeit. Gewünschte leitende Verbindungen zwischen den Leiterbahnen AL1 der ersten Leiterbahnebene und solchen (AL2) der zweiten Leiterbahnebene sind über Kontaktlöcher KL hergestellt, wobei innerhalb der Kontaktlöcher KL die Leiterbahnen AL2 der zweiten Leiterbahnebene direkt auf denen (AL1) der ersten Leiterbahnebene angeordnet sind. Aufgrund von Strukturierungsmaßnahmen bezüglich der ersten und zweiten Isolierschicht IS1, IS2 bilden diese Isolierschichten IS1, IS2 an Rändern der Kontaktlöcher KL offene Flanken F1. An diesen Flanken F1 ist die erste Isolierschicht IS1 vor dem Aufbringen der zweiten Leiterbahnebene insbesondere gegenüber eindringender Feuchtigkeit ungeschützt. Dies ist in Fig. 2 dargestellt. In diesem Stadium der Herstellung des bekannten Schaltkreises eindringende Feuchtigkeit führt zu negativen Veränderungen elektrischer Parameter des Schaltkreises, insbesondere zu deren Instabilität. Des weiteren treten Zuverlässigkeitsprobleme bei der zweiten und weiteren Leiterbahnebenen auf.

Beim herkömmlichen Herstellungsverfahren wird deshalb vor dem Aufbringen der zweiten Leiterbahnebene versucht, durch Ausheizen in die Schaltkreise eingedrungene Feuchtigkeit wieder zu entfernen. Dies gelingt jedoch nur unvollkommen. Außerdem kann anschließend wiederum Feuchtigkeit eindringen, wenn nicht die zweite Leiterbahnebene sofort anschließend an das Ausheizen aufgebracht wird.

Aufgabe der vorliegenden Erfindung ist es deshalb, einen integrierten Schaltkreis mit Mehrlagenverdrahtung und ein Verfahren zu seiner Herstellung zu schaffen, bei dem keine Feuchtigkeit eindringen kann und somit bei seiner Herstellung das Ausheizen entfällt.

Diese Aufgabe wird erfindungsgemäß durch die kennzeichnenden Teile der Patentansprüche 1 und 7 gelöst.

Vorteilhafte Weiterbildungen der Erfindung sind in Unteransprüchen gekennzeichnet. Die Erfindung ist anwendbar unabhängig von der Art der verwendeten Halbleitertechnologie (bipolar, MOS, MIS, SOS,ESFI, III/V-Halbleiter, usw.).

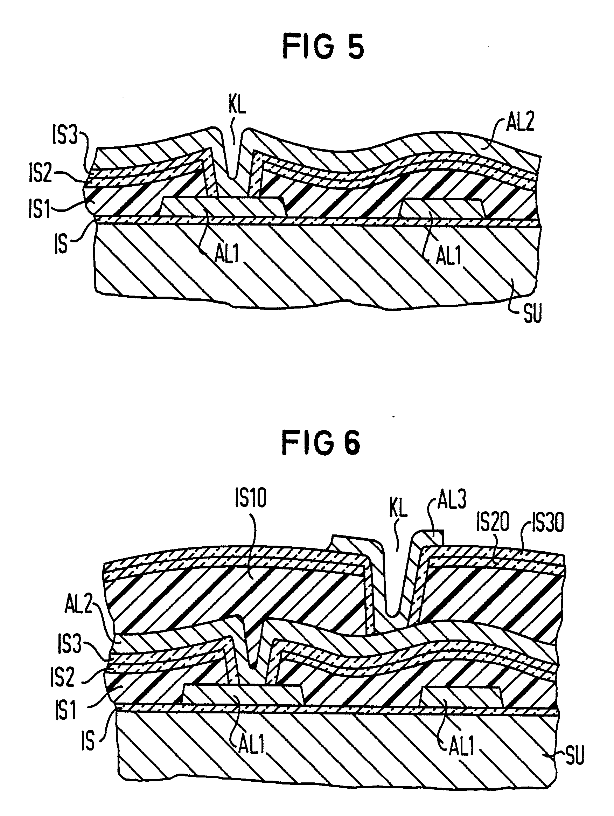

Die Erfindung wird im folgenden anhand der Figuren 1 bis 16 näher erläutert. Es zeigen, jeweils Auszugsweise im Querschnitt:

Fig. 1 einen nach dem bekannten Herstellverfahren erzeugten Schaltkreis,

Fig. 2 ein Zwischenstadium während des bekannten Verfahrens, zu dessen Zeitpunkt die erste Isolierschicht IS1 an den genannten Flanken F1 vor eindringender Feuchtigkeit ungeschützt ist,

Fig. 3 einen erfindungsgemäßen Schaltkreis nach dem Verfahrensschritt, mit dem eine dritte Isolierschicht IS3 aufgebracht worden ist,

Fig. 4 einen erfindungsgemäßen Schaltkreis nach Umwandlung eines Teiles T der dritten Isolierschicht IS3 innerhalb eines Kontaktloches KL,

Fig. 5 einen erfindungsgemäßen Schaltkreis mit aufgebrachter zweiter Leiterbahnebene,

Fig. 6 einen erfindungsgemäßen Schaltkreis mit aufgebrachter dritter Leiterbahnebene.

In den Figuren sind gleiche Elemente mit gleichen Bezugszeichen versehen. Aus Gründen der Übersichtlichkeit werden nur erfindungswesentliche Einzelheiten dargestellt. Insbesondere wird auf die Darstellung elektrischer Schaltungsteile sowie einer Endpassivierungsschicht verzichtet.

Bei der Herstellung des erfindungsgemäßen Schaltkreises werden zunächst gemäß bekannten Verfahrensschritten auf ein Substrat SU, innerhalb dem sich elektrisch aktive Schaltungsteile befinden, verschiedene Schichten und Ebenen aufgetragen: Als erste Schicht wird eine isolierende Schicht IS abgeschieden. Sie soll die elektrisch aktiven Schaltungsteile innerhalb des Substrates SU vor den noch aufzutragenden Schichten der Mehrlagenverdrahtung isolieren und schützen. Die isolierende Schicht IS kann z.B. überwiegend $SiO_2$ enthalten. Auf die isolierende Schicht IS wird dann eine erste Leiterbahnebene abgeschieden, beispielsweise in Form von Polysilicium, Metallen oder Metallsiliciden. Entsprechend den für den jeweiligen Schaltkreistyp vorliegenden elektrischen Bedingungen wird dann diese Leiterbahnebene, ebenfalls mit bekannten Maßnahmen, zu einzelnen Leiterbahnen AL1 strukturiert. Auf diese Leiterbahnen und die durch das Strukturieren der ersten Leiterbahnebene wieder freiliegende isolierende Schicht IS wird nun als Dielektrikum und Mittel zum Ausgleich von Unebenheiten eine erste Isolierschicht IS1 aufgetragen. Dazu können vor allem organische Materialien wie Polyimide verwendet werden. Durch bekannte Verfahrensschritte wie Temperaturbehandlung oder, im Falle von photovernetzbaren Polyimiden, durch Bestrahlen werden anschließend diese Polyimide vernetzt (zyklisiert) und damit stabilisiert. Organische Materialien, insbesondere Polyimide, haben jedoch die Nachteile, daß sie zum einen hygroskopisch sind und zum anderen gegenüber weiteren, später aufzutragenden Metallisierungsebenen eine geringere Haftfestigkeit besitzen. Außerdem treten bei einer Strukturierung dieser Metallisierungsebenen weitere Probleme auf.

Gemäß DE-OS 3234907 wird deshalb eine zweite hintere Schicht IS2 aufgetragen, die wasserabstoßend ist und z.B. anorganisches Material enthält. Als gut für diesen Zweck geeignet hat sich Siliciumnitrid erwiesen, jedoch ist auch die Verwendung von Siliciumdioxid möglich. Um elektrisch leitende Verbindungen zwischen Leiterbahnen AL2 einer später aufzubringenden Leiterbahnebene und denen (AL1) der ersten Leiterbahnebene zu ermöglichen, werden nach dem bekannten Verfahren in die ersten beiden Isolierschichten IS1, IS2 sogenannte Kontaktlöcher KL geätzt.

Dadurch erhalten jedoch diese Isolierschichten IS1, IS2 an den Rändern der Kontaktlöcher KL offene Flanken F1, wie aus Fig. 2 ersichtlich. Die daraus resultierenden Nachteile wurden bereits beschrieben.

Erfindungsgemäß wird deshalb anschließend an das Erstellen der Kontaktlöcher KL, wodurch die offenen Flanken F1 ja entstehen, eine weitere, dritte Isolierschicht IS3 aufgetragen, die nicht nur die zweite Isolierschicht IS2 bedeckt, sondern auch die offenen Flanken F1 in den Kontaktlöchern KL und durch das Herstellen der Kontaktlöcher KL freigelegte Oberflächenteile der Leiterbahnen AL1 der ersten Leiterbahnebene. Als Material werden Feuchtigkeit abstoßende Stoffe verwendet wie z.B. solche aus der Menge der anorganischen chemischen Verbindungen. Besonders vorteilhaft habe sich Nitridverbindungen erwiesen, insbesondere Siliciumnitrid. Diese dritte Isolierschicht IS3 wird in einer Dicke von 50 nm bis 1,5 µm aufgetragen. Durch das Bedecken der offenen Flanken F1 der Kontaktlöcher KL verringert sich der Durchmesser um etwas weniger als das Doppelte der Dicke der aufgetragenen Isolierschicht IS3. Dies ist jedoch unkritisch, da durch Anpassen von Designregeln ein entsprechender Vorhalt berücksichtigt werden kann. Anschließend wird selektiv ein Teil T der dritten Isolierschicht IS3, nämlich genau der Teil, der die Leiterbahnen AL1 der ersten Leiterbahnebene in den Kontaktlöchern KL direkt bedeckt, chemisch umgewandelt in einen Stoff, der mit Mitteln ätzbar ist, die den (nicht umgewandelten) Rest der dritten Isolierschicht IS3 nicht angreift. Diese Umwandlung kann beispielsweise elektrolytisch erfolgen. Als Elektrolyt eignet sich ganz besonders gut Kalilauge in einer Konzentration von 0,5 bis 10 %. Der solcher Art umgewandelte Teil T der dritten Isolierschicht IS3 wird dann anschließend mittels üblicher Ätztechniken entfernt, so daß zwar einerseits die Leiterbahnen AL1 der ersten Metallisierungsebene innerhalb der Kontaktlöcher KL wieder freiliegen, jedoch andererseits die genannten Flanken FC von der dritten Isolierschicht IS3 bedeckt bleiben. Dazu ist es notwendig, ein Ätzmittel zu verwenden, das das Material dieser dritten Isolierschicht IS3 nicht angreift. Ein geeignetes Mittel ist beispielsweise -HF (-1 bis 10 %) -Fluorwasserstoff in einer Konzentration von 1 bis 10 %.

Jetzt wird in üblicher Technik, beispielsweise durch Sputtern oder Aufdampfen, Material für eine zweite Leiterbahnebene aufgetragen. Durch bekanntes Strukturieren derselben erhält man die gewünschten Leiterbahnen AL2, die in den Kontaktlöchern KL elektrisch mit den Leiterbahnen AL1 der ersten Leiterbahnebene verbunden sind.

Auf die vorstehend beschriebene, vorteilhafte Art und Weise erhält man einen erfindungsgemäßen Halbleiterschaltkreis in Zwei-Lagenverdrahtungstechnik. Will man erfindungsgemäße Halbleiterschaltkreise mit mehr als Zwei-Lagenverdrahtungstechnik herstellen, so bringt man auf die strukturierte zweite Leiterbahnebene weitere drei Isolierschichten IS10, IS20, IS30, die in Aufbringen und Behandeln (Strukturieren) den ersten drei Isolierschichten IS1, IS2, IS3 entsprechen. Insbesondere wird die letztere Isolierschicht IS30, analog zur dritten Isolierschicht IS3, durch elektrolytische Umwandlung eines Teiles T derselben und Entfernen dieses Teiles T (z.B. Ätzen) behandelt wie vorstehend beschrieben. Daran schließen sich Aufbringen und Strukturieren einer weiteren, dritten Leiterbahnebene an. Diese Verfahrensschritte "Aufbringen und Strukturieren von drei Isolierschichten" und "Aufbringen und Strukturieren einer weiteren Leiterbahnebene" werden solange wiederholt, bis alle gewünschten Lagen der Mehrlagenverdrahtung aufgebracht sind.

Damit ist ein erfindungsgemäßer Halbleiterschaltkreis hergestellt worden mit Hilfe des beschriebenen, vorteilhaften Verfahrens.

Weitere, bekannte Schritte wie Aufbringen einer Endpassivierung können sich noch anschließen, sind jedoch nicht mehr Bestandteil der Erfindung.

**Ansprüche**

1. Integrierter Schaltkreis mit Mehrlagenverdrahtung, mit einer isolierenden Schicht (IS), die innerhalb eines Substrates (SU) befindliche, elektrisch aktive Schaltungsteile von der Mehrlagenverdrahtung trennt, der oberhalb der isolierenden Schicht (IS) mindestens folgende Lagen enthält:

a) eine erste Leiterbahnebene mit Leiterbahnen (AL1),

b) eine erste Isolierschicht (IS1) aus hygroskopischem, vorzugsweise organischem Material als Dielektrikum und Mittel zum Ausgleich von Unebenheiten,

c) eine zweite, Feuchtigkeit abstoßende Isolierschicht (IS2) aus vorzugsweise anorganischem Material zum Schutze der darunterliegenden ersten Isolierschicht (IS1) vor Eindringen von Feuchtigkeit,

d) eine zweite Leiterbahnebene mit Leiterbahnen (AL 2) wobei Leiterbahnen (AL2) der zweiten Leiterbahnebene mit Leiterbahnen (AL1) der ersten Leiterbahnebene über Kontaktlöcher (KL) elektrisch verbunden sind,

**dadurch gekennzeichnet,** daß zwischen der zweiten, Feuchtigkeit abstoßenden Isolierschicht ( IS2) und der zweiten Leiterbahnebene mit ihren Leiterbahnen (AL2) eine dritte, Feuchtigkeit abstoßende Isolierschicht (IS3) angeordnet ist in der Form, daß sie an den Kontaktlöchern (KL) offenliegende Flanken (F1) der ersten und zweiten Isolierschicht (IS1, IS2) mit bedeckt.

2. Integrierter Schaltkreis nach Anspruch 1, **dadurch gekennzeichnet,** daß die dritte, Feuchtigkeit abstoßende Isolierschicht (IS3) überwiegend anorganisches Material enthält.

3. Integrierter Schaltkreis nach Anspruch 1 oder 2, **dadurch gekennzeichnet,** daß die dritte, Feuchtigkeit abstoßende Isolierschicht (IS3) überwiegend Siliciumnitrid enthält.

4. Integrierter Schaltkreis nach einem der Ansprüche 1, 2 oder 3, **dadurch gekennzeichnet** daß die dritte Isolierschicht (IS3) zwischen 50 nm und 1,5 µm dick ist.

5. Integrierter Schaltkreis nach einem der Ansprüche 1 bis 4, **dadurch gekennzeichnet** daß oberhalb der zweiten Leiterbahnebene weitere Leiterbahnebenen mit Leiterbahnen (AL3) angeordnet sind, wobei Leiterbahnen (AL3) der weiteren Leiterbahnebenen jeweils mit Leiterbahnen (AL2) der jeweils darunterliegenden Leiterbahnebene elektrisch über Kontaktlöcher (KL) verbunden sind.

6. Integrierter Schaltkreis nach Anspruch 5, **dadurch gekennzeichnet,** daß jede der weiteren Leiterbahnebenen mit Leiterbahnen (AL3) von der jeweils darunterliegenden Leiterbahnebene durch drei Isolierschichten (IS10, IS20, IS30) getrennt sind, die in ihrer Beschaffenheit und Anordnung der ersten, zweiten und dritten Isolierschicht (IS1, IS2, IS3) jeweils entsprechen.

7. Verfahren zur Herstellung eines integrierten Schaltkreises mit Mehrlagenverdrahtung gemäß Anspruch 1, mit einer isolierenden Schicht (IS), die innerhalb eines Substrates (SU) befindliche, elektrisch aktive Schaltungsteile von der Mehrlagenverdrahtung trennt, der oberhalb der isolierenden Schicht (IS) mindestens folgende Lagen enthält:

a) eine erste Leiterbahnebene mit mindestens einer Leiterbahn (AL1),

b) eine erste Isolierschicht (IS1) aus hygroskopischem. vorzugsweise organischem Material als Dielektrikum und Mittel zum Ausgleich von Unebenheiten,

c) eine zweite, Feuchtigkeit abstoßende Isolierschicht (IS2) aus vorzugsweise anorganischem Material, wobei die zweite Isolierschicht (IS2) und unter Verwendung dieser zweiten Isolierschicht (IS2) als Strukturierungsmaske, anschließend die erste Isolierschicht (IS1) zur Erzeugung von Kontaktlöchern (KL) zwischen einer zweiten, später aufzutragenden Leiterbahnebene und der ersten Leiterbahnebene strukturiert werden,

**gekennzeichnet** durch

1) ganzflächiges Auftragen einer weiteren, dritten, Feuchtigkeit abstoßenden Isolierschicht (IS3) auf die zweite Isolierschicht (IS2) und die Kontaktlöcher (KL), wobei an den Kontaktlöchern (KL) zunächst seitlich offenliegende Flanken (F1) der ersten und zweiten Isolierschicht (IS1, IS2) mit bedeckt werden, und dadurch die Kontaktlöcher (KL) im Durchmesser etwas verkleinert werden,

2) selektive chemische Umwandlung eines Teiles T der dritten Isolierschicht (IS3), der sich auf den Leiterbahnen (AL1) der ersten Leiterbahnebene innerhalb der Kontaktlöcher (KL) befindet, wobei ein die Flanken (F1) der ersten beiden Isolierschichten (IS1, IS 2) bedeckender anderer Teil der dritten Isolierschicht (IS3) bis herunter zu den Leiterbahnen (AL1) der ersten Leiterbahnebene von der chemischen Umwandlung ausgenommen bleibt, in ein Material, das mit Mitteln ätzbar ist, die den verbleibenden, chemisch unveränderten Rest der dritten Isolierschicht (IS3) nicht angreifen,

3) Entfernen des chemisch umgewandelten Teiles T der dritten Isolierschicht (IS3) durch Ätzen desselben, sodaß einerseits die Leiterbahnen (AL1) der ersten Leiterbahnebene innerhalb der nunmehr im Durchmesser etwas verkleinerten Kontaktlöcher (KL) wieder freiliegen, und andererseits jedoch die Flanken (F1) der Kontaktlöcher (KL) weiterhin mit der dritten Isolierschicht (ES 3) bedeckt bleiben,

4) ganzflächiges Auftragen einer zweiten Leiterbahnebene und Strukturieren derselben zu Leiterbahnen (AL2) mit elektrischem Kontakt zu den Leiterbahnen (AL1) der ersten Leiterbahnebene in den Kontaktlöchern (KL).

8. Verfahren nach Anspruch 7, **dadurch gekennzeichnet,** daß die 3. Isolierschicht (IS3) aus einer anorganischen chemischen Verbindung besteht.

9. Verfahren nach Anspruch 7, **dadurch gekennzeichnet,** daß die dritte Isolierschicht (IS3) überwiegend eine anorganische, chemische Verbindung enthält.

10. Verfahren nach Anspruch 8 oder 9, **dadurch gekennzeichnet,** daß als chemische Verbindung Nitrid, vorzugsweise Siliciumnitrid Verwendet wird.

11. Verfahren nach einem der Ansprüche 7 bis 10, **dadurch gekennzeichnet,** daß die dritte Isolierschicht (IS3) in einer Dicke von 50 nm bis 1,5 μm aufgetragen wird.

12. Verfahren nach einem der Ansprüche 7 bis 11, **dadurch gekennzeichnet,** daß die chemische Umwandlung elektrolytisch unter Verwendung eines geeigneten Elektrolyten erfolgt.

13. Verfahren nach Anspruch 12, **dadurch gekennzeichnet,** daß als Elektrolyt Kalilauge verwendet wird.

14. Verfahren nach Anspruch 13, **dadurch gekennzeichnet,** daß die Kalilauge in einer Konzentration von 0,5 bis 10% verwendet wird.

15. Verfahren nach einem der Ansprüche 7 bis 14, **dadurch gekennzeichnet,** daß als Ätzmittel zum Entfernen des umgewandelten Teiles T der dritten Isolierschicht (IS3) Fluorwasserstoff in einer Konzentration von 1 bis 10 % verwendet wird.

16. Verfahren nach einem der Ansprüche 7 bis 15, **gekennzeichnet** durch

a) Auftragen und Strukturieren von weiteren drei Isolierschichten (IS10, IS20, IS30) und einer dritten Leiterbahnebene mit Kontaktlöchern (KL1) zu den Leiterbahnen (AL2) der darunter liegenden zweiten Leiterbahnebene in der selben Art, wie die ersten drei Isolierschichten (IS1, IS2, IS3) und die zweite Leiterbahnebene aufgetragen und strukturiert werden,

b) Wiederholen der Maßnahmen nach a) bis alle benötigten Leiterbahnebenen mit Leiterbahnen aufgetragen und strukturiert sind.

FIG 1

FIG 2

FIG 3

FIG 4

## FIG 5

## FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 451 326 (P.S. GWOZDZ)<br><br>* Figur 9; Spalte 5, Zeilen 14-24 *<br><br>--- | | H 01 L 23/52<br>H 01 L 21/90 |
| A | PATENTS ABSTRACTS OF JAPAN, Band 7, Nr. 251 (E-209) [1396], 8. November 1983; & JP - A - 58 137 258 (MITSUBISHI DENKI K.K.) 15-08-1983<br>* Insgesamt *<br><br>--- | | |
| A | IBM TECHNICAL DISCLOSURE BULLETIN, Band 25, Nr. 11B, April 1983, Seiten 6055-6056, New York, US; R. MARKS u.a.: "Hermetic sealing of IC chips"<br>* Insgesamt *<br><br>--- | | |
| A | EP-A-0 075 454 (FUJITSU)<br><br>* Zusammenfassung *<br><br>--- | | |
| A | EP-A-0 010 596 (IBM)<br><br>* Zusammenfassung *<br><br>----- | | |

RECHERCHIERTE SACHGEBIETE (Int. Cl.4)

H 01 L

Der vorliegende Recherchenbericht wurde für alle Patentansprüche erstellt.

| Recherchenort | Abschlußdatum der Recherche | Prüfer |
|---|---|---|
| DEN HAAG | 16-12-1985 | DE RAEVE R.A.L. |